# EUROPÄISCHE PATENTANMELDUNG

(11) **EP 0 938 252 A2**
(43) Veröffentlichungstag der Anmeldung: **25.08.1999**
(21) Anmeldenummer: 99102302.9
(22) Anmeldetag: 05.02.1999
(51) Int. Cl.: H05K 1/02, H05K 1/14, H05K 7/20

(54) **Elektrische Schaltungsanordnung**

(30) Priorität: 18.02.1998 DE 19806801
(71) Anmelder: SIEMENS AKTIENGESELLSCHAFT, 80333 München (DE)
(72) Erfinder: Franzen, Frank, 93049 Regensburg (DE); Loibl, Josef, 94209 Regen (DE)

(57) **Zusammenfassung**

Eine Schaltungsanordnung weist einen als flexibler Leiterbahnträger ausgelegten Schaltungsträger und auf dem Schaltungsträger angeordnete elektrische Bauelemente auf. Der Schaltungstrager ist im Bereich unterhalb der elektrischen Bauelemente mit einer Aussparung versehen und die elektrischen Bauelemente sind durch die Aussparung hindurch mittels eines wärmeleitenden Klebers thermisch mit einer Wandfläche eines die Schaltungsanordnung umgebenden Gehäuses gekoppelt.

## Beschreibung

Die Erfindung betrifft elektrische Schaltungsanordnungen nach den Oberbegriffen der Ansprüche 1, 4 und 9.

Bei Schaltungsträgern, die mit Leistungsbauelementen bestückt sind, spielt die Frage der Wärmeabführung während des Betriebs eine zentrale Rolle. Insbesondere bei Schaltungsträgern, die in Motor- oder Getriebesteuergeräten für Personenkraftwagen eingesetzt werden, muß zur Gewährleistung der Betriebssicherheit der Elektronik sowie einer langen Lebensdauer einer möglichen Überhitzung des Schaltungsträgers wirkungsvoll entgegengewirkt werden. Bei Integration der genannten Steuergeräte in einen Motor bzw. in ein Getriebe (sogenannte "Vor-Ort-Elektronik") werden die Anforderungen an eine geeignete Wärmeabführung noch erhöht. Neben der erhöhten Umgebungstemperatur liegt dies auch daran, daß bei in Motoren oder Getrieben integrierten Schaltungsträgern eine Reparatur derselben sehr aufwendig und kostenintensiv ist, da diese Schaltungsträger von außen nur schwer zugänglich sind. Folglich kann eine durch mangelhafte Wärmeabführung bewirkte verkürzte Lebensdauer oder erhöhte Ausfallwahrscheinlichkeit bei integrierten Komponenten noch weniger hingenommen werden als dies bei frei zugänglichen elektronischen Bauelementen der Fall ist.

Die deutsche Patentanmeldung DE 36 31 963 A1 beschreibt ein Verfahren zur Herstellung einer Flachbaugruppe, bei dem zunächst Leistungshalbleiter-Bauelemente auf eine Leiterplatte mittels Schwallbadverlötung elektrisch kontaktiert werden und nachfolgend unterhalb der Leistungshalbleiter liegende Ausbrechelemente der Leiterplatte entfernt werden, um die Leistungshalbleiter durch die so geschaffenen Ausnehmungen mit einem Kühlkörper zu verbinden, der an der den Bauteilen abgewandten Seite der Leiterplatte angeordnet ist. Der Wärmekontakt zwischen den Leistungshalbleitern und dem Kühlkörper wird dabei durch Schraubverbindungen hergestellt.

Die europäische Patentschrift EP 0 588 793 B1 beschreibt ein Gehäuse für eine Kraftfahrzeugelektronik, in dem eine Leiterplatte, die auch als Multilayerfolie ausgebildet sein kann, oberhalb einer Gehäusegrundplatte angeordnet ist und Leistungshalbleiter-Bauelemente randseitig an die Leiterplatte kontaktiert und mit ihrem Bauteilkörper auf die Grundplatte aufgeklebt sind. Die bei einem Betrieb der Leistungshalbleiter entstehende Wärme wird über die Klebverbindung zu der Grundplatte hin abgeführt.

In der europäischen Patentanmeldung EP 00 85 622 A2 ist eine bauteilbestückte Leiterplatte beschrieben, an deren rückwärtiger Seite ein Kühlkörper angebracht ist. Der Kühlkörper weist durch Öffnungen der Leiterplatte hindurchtretende Erhebungen auf, die mit den Bauteilen in thermischem Kontakt stehen.

In dem Buch "Handbook of flexible Circuits", von K. GILLEO, New York, Van Nostrand Reinhold, 1992, Seiten 87-89 ist beschrieben, daß bei einer flexiblen Leiterplatte ebene Gehäusewandungen zur Wärmeabführung genutzt werden können.

Die europäische Patentanmeldung EP 04 89 958 A1 und die deutsche Patentanmeldung DE 42 20 966 A1 beschreiben Schaltungsanordnungen, bei denen die von einem elektrischen Bauteil erzeugte Wärme über als Wärmebrücken wirkende Zwischenstücke durch eine Leiterplatte hindurch auf eine Gehäusewandung geleitet wird.

Der vorliegenden Erfindung liegt die Aufgabe zugrunde, eine Schaltungsanordnung zu schaffen, die einfach aufgebaut und kostengünstig herstellbar ist und gleichzeitig ein gutes Wärmeableitungsverhalten aufweist. Diese Aufgabe wird durch Schaltungsanordnungen jeweils gemäß den kennzeichnenden Merkmalen der Ansprüche 1, 4 und 9 gelöst.

Nach einem ersten Aspekt der Erfindung ist der Schaltungsträger eine flexible Leiterplatte, die im Bereich des oder der elektrischen Bauelemente Aussparungen aufweist, durch die die elektrischen Bauelemente mittels eines wärmeleitenden, elektrisch isolierenden Klebers an eine darunterliegende Kühlfläche wärmeableitungsmäßig gekoppelt sind. Aufgrund der flexiblen Leiterplattenstruktur können die Aussparungen vor der Bestückung der Leiterplatte mit den elektrischen Bauelementen problemfrei durch Ausstanzung erzeugt werden. Kostensenkend wirkt sich ferner aus, daß als Kühlfläche kein separater Kühlkörper, sondern die Wandfläche des Gehäuses verwendet wird. Durch die gehäuseseitige Wärmeabführung wird ein sehr effektiver Wärmeabtransport ermöglicht. Der einfache Aufbau der erfindungsgemäßen Schaltungsanordnung wird ferner durch die Verwendung einer Klebverbindung zwischen Bauelement und Gehäusewand gefördert. Durch die im Bereich der thermischen Kopplung mit dem Bauelement vorgesehene Erhebung wird die Wärmeabführung weiter begünstigt, da die Dicke der zwischen Bauelement und metallischer Wandfläche liegenden Kleberschicht auf einen minimalen Wert vermindert werden kann. Solche durch Klebverbindungen realisierte Wärmebrücken sind einfach realisierbar und haben den Vorteil, daß keine Passungsprobleme auftreten können.

Eine auch aus herstellungstechnischer Sicht besonders zweckmäßige Ausgestaltung der Erfindung kennzeichnet sich dadurch, daß die Grundplatte des Gehäuses die Kühlfläche bildet und die flexible Leiterplatte auf die Grundplatte des Gehäuses auflaminiert ist. Dadurch wird ein sicherer Halt der Leiterplatte in dem Gehäuse gewährleistet.

Nach einem zweiten Aspekt der vorliegenden Erfindung besteht der Schaltungsträger aus einem festen Substrat, wobei zwischen der Unterseite des Bauelements und der Oberseite des Substrats ein wärmeleitender Kleber vorgesehen ist, der das elektrische Bauelement mit dem Substrat koppelt und dabei ermöglicht, daß die in dem Bauelement erzeugte Wärme über die unter dem Substrat angeordnete Kühlfläche und der dort vorgesehenen weiteren Klebeverbindung wirkungsvoll abgeführt werden kann.

Ein dritter Aspekt der vorliegenden Erfindung betrifft eine Schaltungsanordnung, bei der ein Schaltungsträger, insbesondere ein Substrat, mit einer benachbart angeordneten flexiblen Leiterplatte in elektrischem Kontakt steht. Ein wesentliches Merkmal dieser Erfindung besteht darin, daß auf der flexiblen Leiterplatte ein oder mehrere elektrische Bauelemente angeordnet sind und durch eine Aussparung in der flexiblen Leiterplatte mittels eines wärmeleitenden Klebers thermisch mit der Kühlfläche gekoppelt sind. Diese "Auslagerung" von elektrischen Bauelementen von dem Schaltungsträger auf die flexible Leiterplatte ist deshalb besonders vorteilhaft, weil das oder die auf der flexiblen Leiterplatte kontaktierte(n) Bauelement(e) über die dort vorgesehene(n) Aussparung(en) besonders wirkungsvoll thermisch mit der darunterliegenden Kühlfläche gekoppelt werden kann (können), während die auf dem Schaltungsträger angeordneten Bauelemente aufgrund des dazwischen liegenden Schaltungsträgers eine vergleichsweise schlechtere thermische Kopplung mit der Kühlfläche aufweisen.

Nach einer vorteilhaften Ausgestaltung handelt es sich bei den ausgelagerten zweiten elektrischen Bauelementen deshalb um Leistungsbauelemente, die einer besonders ausgeprägten Wärmeabführung bedürfen.

Wenn die flexible Leiterplatte den Schaltungsträger seitlich vollständig umgibt, ermöglicht dies, die zweiten elektrischen Bauelemente an beliebigen Stellen um den Schaltungsträger herum lagemäßig anzuordnen. Dadurch kann die Schaltkreistopologie auf dem Schaltungsträger einfach gehalten werden.

Weitere vorteilhafte Ausgestaltungen der Erfindung sind in den Unteransprüchen angegeben.

Die Erfindung wird im folgenden beispielhaft anhand von Ausführungsbeispielen beschrieben, die in der Zeichnung dargestellt sind. In dieser zeigt:
- Fig. 1: eine schematische Querschnittansicht eines Ausführungsbeispiels nach dem ersten Aspekt der vorliegenden Erfindung;
- Fig. 2: eine Draufsicht auf eine flexible Leiterbahnfolie, wie sie in der Fig. 1 verwendet wird;
- Fig. 3: eine schematische Querschnittansicht eines Ausführungsbeispiels gemäß dem zweiten Aspekt der vorliegenden Erfindung;
- Fig. 4: eine Draufsicht auf den in Fig. 3 dargestellten Schaltungsträger;
- Fig. 5: eine schematische Querschnittansicht eines Ausführungsbeispiels nach dem dritten Aspekt der vorliegenden Erfindung;
- Fig. 6: eine schematische Querschnittansicht eines weiteren Ausführungsbeispiels nach dem dritten Aspekt der vorliegenden Erfindung; und
- Fig. 7: eine Draufsicht auf eine flexible Leiterbahnfolie mit Schaltungsträger, wie sie in den Fig. 5 und 6 verwendet wird.

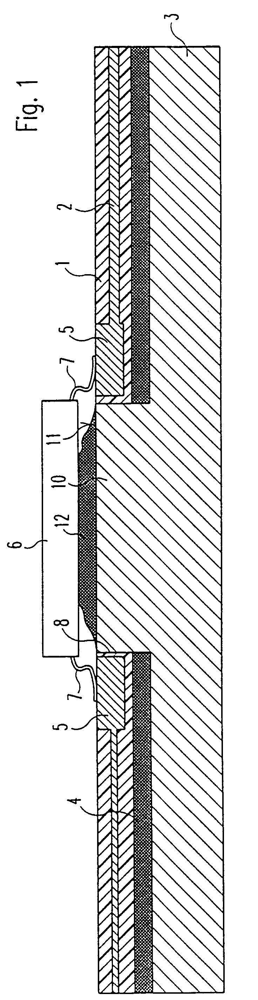

In Fig. 1 ist eine flexible Leiterbahnfolie 1 mit integrierten Leiterbahnen 2 (d.h. eine flexible Leiterplatte) oberhalb einer Grundplatte 3 eines nicht dargestellten Gehäuses, beispielsweise das Gehäuse eines Motor- oder Getriebesteuergerätes, angeordnet. Die Leiterbahnfolie 1 ist mit der Grundplatte 3 über einen zwischen der Unterseite der Leiterbahnfolie 1 und der Oberseite der Grundplatte 3 aufgebrachten Kleber (z.B. Acrylkleber) 4 thermisch gekoppelt.

An den freien Enden der in Fig. 1 dargestellten Leiterbahnen 2 sind an der Leiterbahnfolie 1 oberflächenseitig freiliegende Kontaktpads 5 vorgesehen. An den Kontaktpads 5 ist ein vertikal oberhalb der flexiblen Leiterbahnfolie 1 angeordnetes elektrisches Bauelement 6 über Kontaktbeine 7 oder Bondungen elektrisch mit den integrierten Leiterbahnen 2 verbunden. Im Bereich unterhalb des elektrischen Bauelements 6 weist die Leiterbahnfolie 1 erfindungsgemäß eine Ausstanzung 8 auf, deren seitliche Abmessungen im wesentlichen den seitlichen Bauelementdimensionen entsprechen. In dem Bereich unterhalb des elektrischen Bauelements 6 ist eine Erhebung 10 der Grundplatte 3 vorgesehen. Die seitlichen Abmessungen der Erhebung 10 entsprechen im wesentlichen der freien Weite der Ausstanzung 8, so daß die Erhebung 10 paßgenau durch die Ausstanzung 8 hindurchtritt. Dadurch wird eine lagemäßige Ausrichtung der Leiterbahnfolie 1 an der Erhebung 10 bewirkt.

Zwischen der Oberfläche 11 der Erhebung 10 und der Unterseite des elektrischen Bauelements 6 ist eine Füllung 12 aus einem wärmeleitenden Klebermaterial vorgesehen. Aufgrund der Erhebung 10 kann die Höhe der Füllung 12 gering sein. Da die metallische Grundplatte 3 und Erhebung 10 eine bessere Wärmeleitfähigkeit als das Klebermaterial der Füllung 12 aufweisen, wird durch das Vorsehen der Erhebung 10 eine noch ausgeprägtere wärmemäßige Anbindung des elektrischen Bauelements 6 an die Grundplatte 3 erzielt, als dies nach dem ersten Ausführungsbeispiel gemäß Fig. 1 der Fall ist.

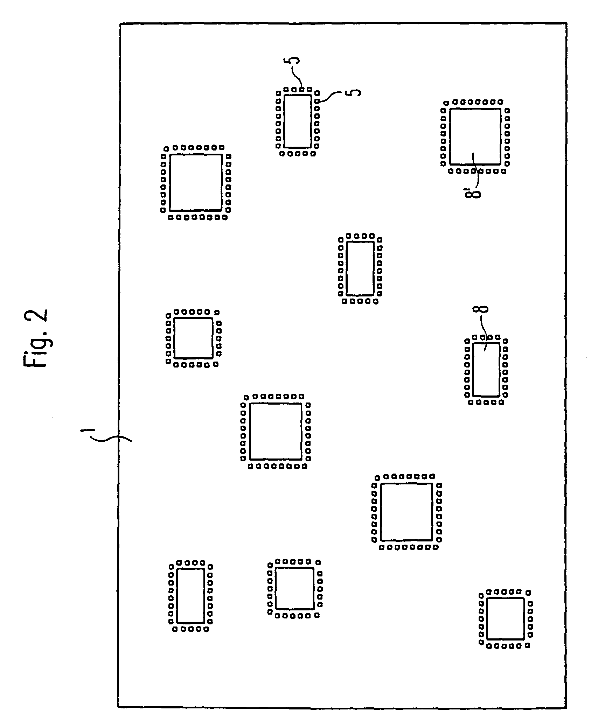

Die Oberfläche 11 der Erhebung 10 kann im wesentlichen bündig mit der Oberfläche der Leiterbahnfolie 1 sein, wie dies in Fig. 2 gezeigt ist. Es ist jedoch auch möglich, die Höhe der Erhebung 10 so zu wählen, daß die Oberfläche 11 der Erhebung 10 bei auflaminierter Leiterbahnfolie 1 über die Oberfläche derselben hinaussteht und praktisch unmittelbar in Anlage zu der Unterseite des elektrischen Bauelements 6 gelangt. Auf diese Weise wird die für die Füllung 12 erforderliche Klebermenge minimiert und die thermische Anbindung weiter verbessert.

Es wird ein möglichst großflächiger Kontakt zwischen der Füllung 12 und der Unterseite des elektrischen Bauelements 6 sowie der Füllung 12 und der Erhebung 10 angestrebt, um eine möglichst große, für die Wärmeleitung nutzbare Querschnittfläche zu erzielen. Ferner wird ein Wärmeleitkleber mit einer besonders hohen spezifischen Wärmeleitfähigkeit verwendet.

Bei dieser Anordnung dient die Füllung 12 somit als Wärmebrücke und die Grundplatte 3 dient als Wärmesenke.

Fig. 2 zeigt in Draufsicht die in den Fig. 1 verwendete, auf die Grundplatte 3 auflaminierte Leiterbahnfolie 1. Es sind Ausstanzungen 8, 8' mit unterschiedlicher Grundrißform erkennbar. Um die Ausstanzungen 8, 8' herum sind die Kontaktpads 5 für die elektrischen Bauelemente angeordnet. Die mit den Kontaktpads 5 verbundenen integrierten Leiterbahnen der Leiterbahnfolie 1 sind in Fig. 2 nicht erkennbar.

Die Lage und Form der Ausstanzungen 8, 8' kann je nach den Erfordernissen der elektronischen Schaltung sehr flexibel gewählt werden.

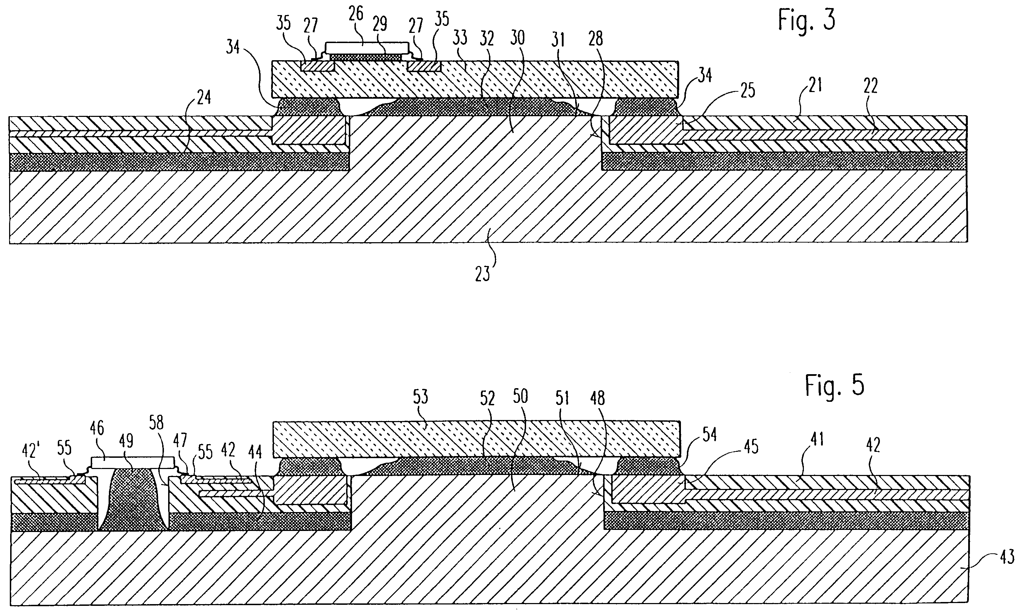

Fig. 3 zeigt ein Ausführungsbeispiel einer erfindungsgemäßen Schaltungsanordnung nach dem zweiten Aspekt der vorliegenden Erfindung. Wiederum ist eine flexible Leiterbahnfolie 21 mit integrierten Leiterbahnen 22 und endseitigen Kontaktpads 25 vorgesehen, die mit einer Kleberfolie 24 auf eine Grundplatte 23 aus Aluminium auflaminiert ist. Im Bereich einer Ausstanzung 28 der Leiterbahnfolie 21 weist die Grundplatte 23 eine Erhebung 30 auf. Die lagemäßige Beziehung zwischen der Erhebung 30 und der Ausstanzung 28 entspricht der in Fig. 1 dargestellten Situation.

Die Grundplatte 23 bildet wiederum den Gehäuseboden eines nicht dargestellten Gehäuses insbesondere eines Getriebesteuergeräts, das zur Aufnahme in den Innenraum eines Getriebes vorgesehen ist.

Als Schaltungsträger ist ein Keramik-Substrat (LTCC-Substrat) 33 vorgesehen, das randseitig über einen Silberleitkleber 34 elektrisch mit den Kontaktpads 25 der flexiblen Leiterbahnfolie 21 in Verbindung steht. Auf dem Substrat 33 verlaufen nicht dargestellte Leiterbahnen zu Kontaktpads 35, die in der Nähe eines elektrischen Bauelements 26 angeordnet sind. Das elektrische Bauelement 26 ist über Kontaktbeine 27 mit den substratseitigen Kontaktpads 35 kontaktiert. Zwischen der Unterseite des Bauelements 26 und der darunterliegenden Oberfläche des Substrats 33 ist eine Füllung 29 vorgesehen, die wiederum aus einem Wärmeleitklebermaterial besteht. Das elektrische Bauelement 26 ist über diese Füllung 29 thermisch an das Substrat 33 gekoppelt.

Ferner ist zwischen der Oberfläche 31 der Erhebung 30 der Grundplatte 23 und der Unterseite des Substrats 33 eine weitere Füllung 32 eines wärmeleitenden Materials vorgesehen, über die das Substrat 33 in Wärmeleitverbindung mit der Grundplatte 23 steht. Die beim Betrieb des elektrischen Bauelements 26 erzeugte Wärme wird somit zunächst über die Füllung 29 auf das Substrat 33 und sodann vom Substrat 33 über die Füllung 32 auf die Grundplatte 23 abgeführt.

Der Wärmeleitkleber der Füllung 32 bewirkt auch die mechanische Fixierung des Substrats 33 an der Grundplatte 23. Bei dieser Anordnung ist es von besonderem Vorteil, daß die mechanische Fixierung mittels der Füllung 32 gleichzeitig, d.h. in einem Arbeitsgang, mit der randseitigen elektrischen Kontaktierung des Substrats 33 über den Silberleitkleber 34 erfolgen kann. Das Substrat 33 muß hierfür lediglich von oben in lagemäßiger richtiger Ausrichtung auf die vorbereitete Anordnung bestehend aus Grundplatte 23 und auflaminierter Leiterbahnfolie 21 niedergebracht werden.

Nach einer nicht dargestellten Modifikation kann die Erhöhung 30 auch entfallen und das Substrat 33 direkt auf die ebene Grundplatte 23 aufgeklebt sein.

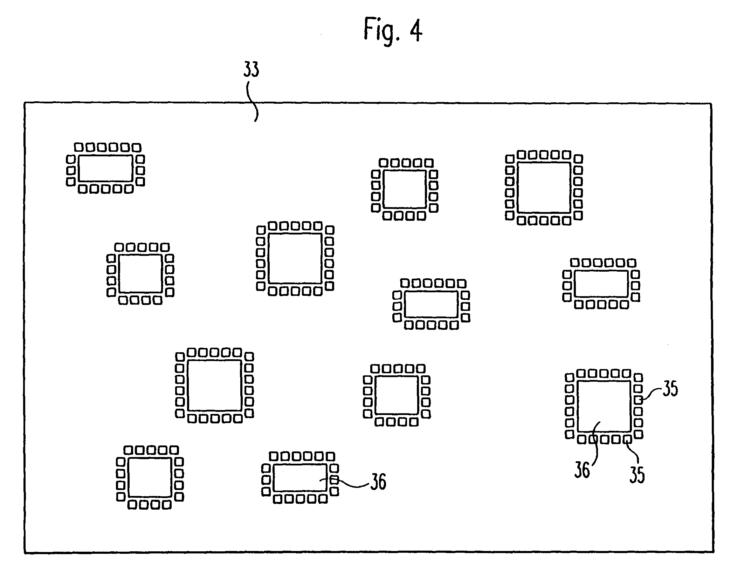

Fig. 4 zeigt das in Fig. 3 als Schaltungsträger verwendete LTCC-Substrat 33 in Draufsicht. Die Freiflächen 36 stellen Substratbereiche dar, die zur Bestückung mit elektrischen Bauelementen 26 vorgesehen sind und gemäß der Darstellung in Fig. 4 als Wärmeabführinseln wirken. Im Außenbereich der Freiflächen 36 sind die substratseitigen Kontaktpads 35 angeordnet, wobei die entsprechenden substratseitigen Leiterbahnen in Fig. 4 nicht erkennbar sind. Die Form der Freiflächen 36 entspricht im wesentlichen der Form der vorgesehenen Bauelemente 26, und ihre lagemäßige Anordnung ist gemäß den Erfordernissen eines geeigneten Schaltungsaufbaus gewählt.

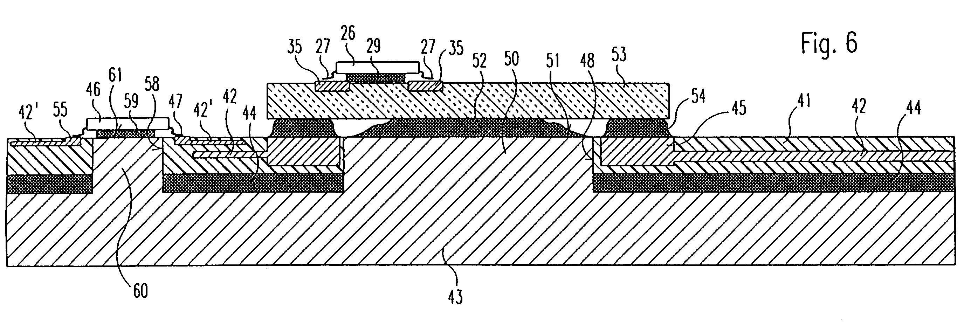

Fig. 5 zeigt ein Ausführungsbeispiel einer erfindungsgemäßen Schaltungsanordnung nach dem dritten Aspekt der vorliegenden Erfindung. In bezug auf die in Fig. 5 dargestellte metallische Grundplatte 43 mit Erhebung 50, die unter Verwendung eines Acrylklebers 44 auflaminierte, flexible Leiterbahnfolie 41 mit integrierten Leiterbahnen 42, die Ausstanzung 48 der Leiterbahnnfolie 41 mit randseitig angeordneten Kontaktpads 45, die Füllung 52 zwischen dem Substrat 53 und der Oberfläche 51 der Erhebung 50 sowie die elektrische Kontaktierung des Substrats 53 mittels eines Silberleitkleber 54 unterscheidet sich die in Fig. 5 dargestellte Ausführungsform nicht von dem Schaltungsaufbau nach Fig. 3. Anders als in Fig. 3 ist hier jedoch das elektrische Bauelement 46 von dem Substrat 53 auf die flexible Leiterbahnfolie 41 ausgelagert, wie dies im linken Teil der Figur 5 erkennbar ist. Hierfür ist das Bauelement 46 über Kontaktbeine 47 mit Kontaktpads 55 der flexiblen Leiterbahnfolie 41 gekoppelt, die mit Leiterbahnen 42', 42 der Leiterbahnfolie 41 in elektrischem Kontakt stehen. Die flexible Leiterbahnfolie 41 weist eine unterhalb des Bauelements 46 vorgesehene weitere Ausstanzung 58 auf, die der in Fig. 1 gezeigten Ausstanzung 8 entspricht. Durch die Ausstanzung 58 hindurch steht das elektrische Bauelement 46 mittels einer Füllung 49 aus Wärmeleitklebermaterial mit der Grundplatte 43 in gutem thermischen Kontakt. Dabei ist zu berücksichtigen, daß aufgrund der geringen Dicke der flexiblen Leiterbahnfolie 41 verhältnismäßig kurze Wärmeableitwege vorliegen und daher die Wärmeableitung von dem Bauteil 46 effizienter gestaltet werden kann, als dies in dem in Fig. 3 dargestellten Beispiel mit substratseitig angebrachten Bauelement 26 der Fall ist. Die ausgelagerten Bauelemente 46 sind daher vorzugsweise Leistungshalbleiter, während andere elektrische Bauelemente mit weniger starker Wärmeentwicklung auf dem Substrat 53 belassen werden können.

Fig. 6 zeigt eine Modifikation der in Fig. 5 dargestellten Schaltungsanordnung, wobei auch hier gleiche Teile mit den gleichen Bezugszeichen bezeichnet sind. Der wesentliche Unterschied zu dem Schaltungsaufbau nach Fig. 5 besteht darin, daß die Grundplatte 43 in Analogie zu dem in Fig. 1 gezeigten Ausführungsbeispiel unter dem Bauelement 46 eine Erhebung 60 aufweist, über deren Oberfläche 61 und eine Füllung 59 aus wärmeleitendem Kleber das Bauelement 46 entsprechen der Beschreibung zu Fig. 1 wärmeableitungsmäßig an die Grundplatte 43 angekoppelt ist. Neben der bereits beschriebenen, nochmals verbesserten thermische Ankoppelung des elektrischen Bauelements 46 ist auch vorteilhaft, daß im Vergleich zu der Schaltungsanordnung nach Fig. 5 eine geringere Menge an Wärmeleitkleber für die Füllung 59 benötigt wird.

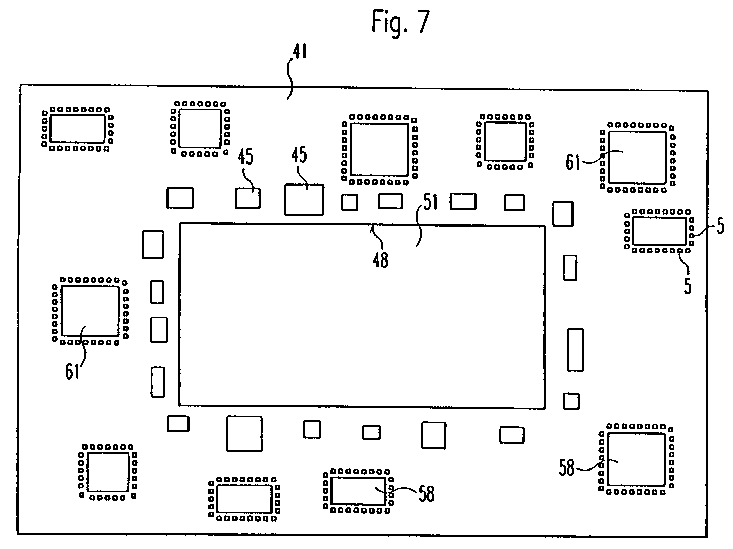

Fig. 7 zeigt eine Draufsicht der in den Fig. 5 und 6 verwendeten flexiblen Leiterbahnfolie 41 im unbestückten aber bereits auf der Grundplatte 43 aufgeklebten Zustand. Um die zentrale Ausstanzung 48 herum sind die Kontaktpads 45 zur Kontaktierung des Substrats 53 angeordnet. Durch die Ausstanzung 48 hindurch ist die Oberfläche 51 der auf der Grundplatte 43 vorhandenen Erhebung 50 sichtbar. Die Ausstanzungen 58 für die ausgelagerten elektrischen Bauelemente 46 sind im peripheren Bereich der Leiterbahnfolie 41 positioniert. Durch die Ausstanzungen 58 sind beim Schaltungsaufbau nach Fig. 5 die jeweiligen darunterliegenden Oberflächenbereiche der Grundplatte 43 und beim Schaltungsaufbau nach Fig. 6 die Oberflächen 61 der Erhebungen 60 sichtbar. Insbesondere kann auch ein gemischter Schaltungsaufbau sowohl mit als auch ohne grundplattenseitigen Erhebungen 60 im Bereich der Ausstanzungen 58 vorgesehen und aufgrund der Ermöglichung einer flexibleren Schaltkreisauslegung zweckmäßig sein.

Sämtliche beschriebenen Ausführungsbeispiele haben gemeinsam, daß eine flexible Leiterbahnfolie - entweder zur Kontaktierung der elektrischen Bauelemente oder des Substrats oder sowohl der Bauelemente als auch des Substrats - zum Einsatz kommt. Dies ist insbesondere dann von wesentlicher Bedeutung, wenn die erfindungsgemäße Schaltungsanordnung in einem Motor- oder Getriebe-integrierten Steuergerät verwendet wird. In diesem Fall kann nämlich durch Fortsätze der flexiblen Leiterbahnfolie 1, 21, 41, die durch einen Dichtspalt zwischen zwei Gehäuseteilen des Steuergerätes durchgeführt sind, eine öldichte und sehr kostengünstige Leitungsdurchführung durch die Gehäusewand des Steuergerätgehäuses erzielt werden, wobei die vorliegende Erfindung durch Verbesserung des Wärmeabführverhaltens das Konzept der Verwendung von Leiterbahnfolien optimal in den Bereich des Schaltungsaufbaus im Steuergerät fortsetzt.

## Patentansprüche

1. Schaltungsanordnung
- mit einer Leiterplatte (1, 2), die mit zumindest einer Aussparung (8) versehen ist,
- mit zumindest einem auf der Leiterplatte (1, 2) im Bereich oberhalb der Aussparung (8) angeordneten, mit elektrischen Leiterbahnen (2) der Leiterplatte (1, 2) elektrisch kontaktierten elektrischen Bauelement (6), und
- mit einer unterhalb der Leiterplatte (1, 2) angeordneten Kühlfläche (3), die eine durch die Aussparung (8) hindurchtretende Erhebung (10) aufweist, wobei
- das elektrische Bauelement (6) durch einen zwischen der Unterseite des Bauelements (6) und der Erhebung (10) vorgesehenen wärmeleitenden Kleber (12) thermisch an die Kühlfläche (3) angekoppelt ist,
**dadurch gekennzeichnet**,
- daß die Leiterplatte (1, 2) eine flexible Leiterplatte (1, 2) ist,
- daß die Kühlfläche (3) mit Erhebung (10) eine Wandfläche eines die Leiterplatte (1, 2) mit Bauelement (6) umgebenden Gehäuses bildet, und
- daß die Erhebung (10) eine lagemäßige Ausrichtung der flexible Leiterplatte (1, 2) relativ zu dem Gehäuse bewirkt.

2. Schaltungsanordnung nach Anspruch 1,
dadurch gekennzeichnet,
- daß als Kühlfläche die Grundplatte (3) des Gehäuses vorgesehen ist, und
- daß die flexible Leiterplatte (1, 2) auf die Grundplatte (3) des Gehäuses auflaminiert ist.

3. Schaltungsanordnung nach Anspruch 1 oder 2,
dadurch gekennzeichnet,
daß in der flexiblen Leiterplatte (1, 2) für jedes thermisch mit der Wandfläche (3) gekoppelte elektrische Bauelement (6) eine eigene Aussparung (8) vorgesehen ist.

4. Schaltungsanordnung,
- mit einer flexiblen Leiterplatte (21, 22), die mit einer Aussparung (28) versehen ist,
- mit einem auf der flexiblen Leiterplatte (21, 22) im Bereich oberhalb der Aussparung (28) angeordneten Schaltungsträger (33) aus einem festen Substrat,
- mit einem auf dem Schaltungsträger (33) angeordneten elektrischen Bauelement (26), das über elektrische Leiterbahnen des Schaltungsträgers (33) mit elektrischen Leiterbahnen (22) der flexiblen Leiterplatte (21, 22) elektrisch kontaktiert ist,
- mit einer unterhalb der flexiblen Leiterplatte (21, 22) und dem Schaltungsträger (33) angeordneten Kühlfläche (23), wobei
- der Schaltungsträger (33) durch die Aussparung (28) hindurch mittels eines zwischen der Unterseite des Schaltungsträgers (33) und der Kühlfläche (23) vorgesehenen ersten wärmeleitenden Klebers (32) thermisch an die Kühlfläche (23) angekoppelt ist, und
- das elektrische Bauelement (26) über einen zwischen der Unterseite des elektrischen Bauelements (26) und der Oberseite des Schaltungsträgers (33) vorgesehenen zweiten wärmeleitenden Kleber (29) thermisch an den Schaltungsträger (33) angekoppelt ist.

5. Schaltungsanordnung nach Anspruch 4,
dadurch gekennzeichnet,
daß der zweite wärmeleitende Kleber (29) im wesentlichen den gesamten Raum zwischen der Unterseite des Bauelements und der darunterliegenden Oberseite des Schaltungsträgers (33) füllt.

6. Schaltungsanordnung nach Anspruch 4 oder 5,
dadurch gekennzeichnet,
daß die Kühlfläche eine Grundplatte (23) eines die flexible Leiterplatte (21, 22) mit Schaltungsträger (33) umgebenden Gehäuses ist.

7. Schaltungsanordnung nach Anspruch 6,
dadurch gekennzeichnet,
daß die Grundplatte (23) des Gehäuses eine durch die Aussparung (28) der flexiblen Leiterplatte hindurchtretende Erhebung (30) aufweist, auf welcher der Schaltungsträger (33) aufgeklebt ist.

8. Schaltungsanordnung nach einem der Ansprüche 4 bis 7,
dadurch gekennzeichnet,
daß der Schaltungsträger (33) aus einem Keramikmaterial besteht.

9. Schaltungsanordnung
- mit einem Schaltungsträger (53),
- mit einem auf dem Schaltungsträger (53) angeordneten, mit Leiterbahnen des Schaltungsträgers (53) elektrisch kontaktierten ersten elektrischen Bauelement (26),
- mit einer benachbart zum Schaltungsträger (53) angeordneten flexiblen Leiterplatte (41), wobei die elektrischen Leiterbahnen des Schaltungsträgers (53) mit elektrischen Leiterbahnen (42) der flexiblen Leiterplatte (41, 42) elektrisch verbunden sind,
- mit einer Kühlfläche (43), von der der Schaltungsträger (53) und die flexible Leiterplatte (41, 42) getragen sind,
- mit einem auf der flexiblen Leiterplatte (41, 42) angeordneten zweiten elektrischen Bauelement (46), das mit Leiterbahnen (42) der flexiblen Leiterplatte (41, 42) elektrisch kontaktiert ist, wobei
- die flexible Leiterplatte (41, 42) im Bereich unterhalb des zweiten elektrischen Bauelements (46) eine Aussparung (58) aufweist, und
- das zweite elektrischen Bauelement (46) durch die Aussparung (58) hindurch mittels eines wärmeleitenden Klebers (49, 59) thermisch mit der Kühlfläche (43) gekoppelt ist.

10. Schaltungsanordnung nach Anspruch 9,
dadurch gekennzeichnet,
daß als Kühlfläche die Grundplatte (43) eines den Schaltungsträger und die flexible Leiterplatte (41, 42) mit zweitem elektrischen Bauelement (46) umgebenden Gehäuses vorgesehen ist.

11. Schaltungsanordnung nach Anspruch 9 oder 10,
dadurch gekennzeichnet,
daß das zweite elektrische Bauelement (46) ein Leistungsbauelement ist.

12. Schaltungsanordnung nach einem der Ansprüche 9 bis 11,
dadurch gekennzeichnet,
daß die Kühlfläche (43) im Bereich der thermischen Kopplung mit dem zweiten elektrischen Bauelement (46) eine zum Bauelement (46) gerichtete Erhebung (60) aufweist.

13. Schaltungsanordnung nach einem der Ansprüche 9 bis 12,
dadurch gekennzeichnet,
daß die flexible Leiterplatte (41, 42) den Schaltungsträger (53) seitlich vollständig umgibt.

14. Schaltungsanordnung nach einem der Ansprüche 9 bis 13,
dadurch gekennzeichnet,
daß in der flexiblen Leiterplatte (41, 42) für jedes zweite Bauelement (46) eine eigene Aussparung (58) vorgesehen ist.

15. Schaltungsanordnung nach einem der Ansprüche 9 bis 14,
dadurch gekennzeichnet, daß der Schaltungsträger (53) über einen wärmeleitenden Kleber (52) thermisch mit der Kühlfläche (43) gekoppelt ist.
